# DEMANDE DE BREVET EUROPEEN

(11) **EP 1 331 724 A2**
(43) Date de publication de la demande: **30.07.2003**
(21) Numéro de dépôt: 03290055.7
(22) Date de dépôt: 10.01.2003
(51) Int. Cl.: H02M 5/27

(54) **Convertisseur matriciel pour la transformation d'énergie électrique**

(30) Priorité: 17.01.2002 FR 0200551
(71) Demandeur: Alstom, 75116 Paris (FR)
(72) Inventeur: Dutarde, Emmanuel, 64800 Mirfpfix (FR); Beuille, Christophe, 65800 Aureilhan (FR); Breit, Fabrice, 65710 Campan (FR); Schneider, Henri, 31071 Toulouse Cédex 7 (FR)
(74) Mandataire: Gosse, Michel

(57) **Abrégé**

Convertisseur matriciel pour la transformation d'énergie électrique entre au moins une source de tension (1), notamment un réseau d'alimentation, et au moins une source de courant (2), notamment une charge, ledit convertisseur comportant une matrice d'interrupteurs (6) reliant lesdites sources de tension (1) audites sources de courant (2), caractérisé en ce que lesdits interrupteurs (6) comportent deux bornes (5) qui sont reliés entre elles par une couchc de diamant photoconductrice (4), la commande de chaque interrupteur (6) étant réalisée au moyen d'une source optique (7) venant irradier la couche de diamant (4) interposée entre les deux bornes (5) de l'interrupteur (6).

## Description

L'invention se rapporte à un convertisseur matriciel pour la transformation d'énergie électrique entre une source de tension, telle qu'un réseau d'alimentation, et une source de courant, telle qu'un moteur. L'invention s'applique notamment à la commande des moteurs de traction du domaine ferroviaire.

Il est connu, de la demande de brevet US 2001/0026427 A1, un convertisseur matriciel comportant une matrice 3x3 composée d'interrupteurs bidirectionnels pour l'alimentation d'un moteur asynchrone à partir d'un réseau triphasé. Un tel convertisseur matriciel présente l'avantage, de part sa topologie modulable, de permettre la conversion directe d'un courant alternatif donné vers un courant alternatif avec une tension et une fréquence différentes par une commande appropriée des différents interrupteurs à la différence des convertisseurs à structure figée habituellement utilisés qui nécessitent d'associer en série un redresseur AC/DC, un hacheur DC/DC et un onduleur DC/AC combinés avec des capacités de filtrage pour obtenir le même résultat.

Toutefois, dans un tel convertisseur matriciel les interrupteurs bidirectionnels sont constitués par l'association de composants IGBT et de diodes qui présentent l'inconvénient de ne pas résister à des tensions trop importantes, les composants IGBT les plus robustes actuellement disponibles dans le commerce étant limités à une tension de fonctionnement de l'ordre de 6,5 kV. De plus, les composants IGBT présentent l'inconvénient de posséder une grille de commande qui doit être isolée de son collecteur et de son émetteur, ce qui pose des problèmes lorsque la tension aux bornes du composant IGBT devient importante.

Aussi, un but de la présente invention est de proposer un convertisseur matriciel d'un type nouveau qui puisse fonctionner avec de fortes tensions. Un autre but de l'invention est de proposer un convertisseur matriciel dont les interrupteurs présentent une commande qui est naturellement isolée des bornes de l'interrupteur.

A cet effet, l'invention a pour objet un convertisseur matriciel pour la transformation d'énergie électrique entre au moins une source de tension, notamment un réseau d'alimentation, et au moins une source de courant, notamment une charge, le convertisseur comportant une matrice d'interrupteurs reliant les sources de tension aux sources de courant, caractérisé en ce que les interrupteurs comportent deux bornes qui sont reliés entre elles par une couche de diamant photoconductrice, la commande de chaque interrupteur étant réalisée au moyen d'une source optique venant irradier la couche de diamant interposée entre les deux bornes de l'interrupteur.

Selon des modes particuliers de réalisation, le convertisseur matriciel selon l'invention peut comprendre l'une ou plusieurs des caractéristiques suivantes prises isolément ou selon toutes les combinaisons techniquement possibles :
- les bornes de la matrice d'interrupteurs sont disposées dans un même plan ;
- la couche de diamant de l'interrupteur est constituée d'un substrat diamant obtenu par un procédé CVD de dépôt chimique en phase vapeur ;
- les bornes sont réalisées par métallisation du substrat diamant par vaporisation successive de Titane-Platine-Or ;
- la source optique est une source ultraviolette ;
- un unique substrat diamant supporte l'ensemble des bornes de la matrice d'interrupteurs ;
- chaque interrupteur du convertisseur est formé par un substrat diamant individuel qui est supporté par un substrat céramique, le substrat diamant individuel étant lié au substrat céramique support par l'intermédiaire d'une couche de verre ;
- chaque interrupteur comporte deux bornes reliées respectivement à une source de tension et à une source de courant par des pistes conductrices portées par le substrat céramique support ;
- le substrat céramique est en nitrure d'aluminium AlN ;
- le substrat céramique comporte une face, opposée à la face supportant les pistes conductrices, qui est refroidie par l'écoulement d'un fluide caloporteur.

On comprendra mieux les buts, aspects et avantages de la présente invention, d'après la description donnée ci-après de deux modes de réalisation de l'invention, présentés à titre d'exemple non limitatif, en se référant aux dessins annexés, dans lesquels :
- la figure 1 est une vue en perspective d'un convertisseur matriciel selon un mode de réalisation particulier de l'invention ;
- la figure 2 est une vue en coupe d'un interrupteur diamant du convertisseur matriciel de la figure 1 ;
- la figure 3 est une vue en perspective d'un convertisseur matriciel selon une variante de réalisation du convertisseur selon l'invention ;
- la figure 4 est une vue de détail d'un interrupteur diamant du convertisseur de la figure 3.

Pour faciliter la lecture du dessin, seuls les éléments nécessaires à la compréhension de l'invention ont été représentés. Les mêmes éléments portent les mêmes références d'une figure à l'autre.

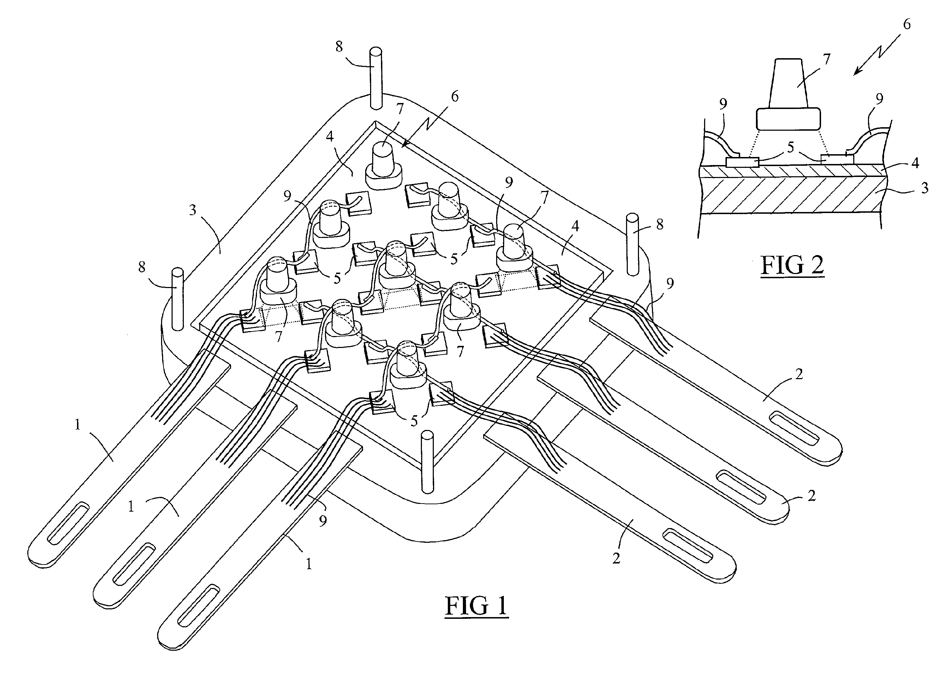

La figure 1 représente un mode de réalisation particulier d'un convertisseur matriciel selon l'invention, ce convertisseur matriciel comportant trois connecteurs d'entrée 1 destinés par exemple à être alimentés par un réseau triphasé et trois connecteurs de sortie 2 destinés par exemple à fournir de l'énergie à un moteur asynchrone.

Conformément à cette figure, le convertisseur matriciel comporte un socle 3 en matière plastique, de forme sensiblement carrée, supportant en son centre un substrat diamant 4. Ce substrat diamant 4 est réalisé de façon connue en soi par un procédé de dépôt chimique en phase vapeur, également appelé procédé CVD et possède par exemple une largeur de l'ordre de 150 mm et une épaisseur de l'ordre de 50 µm.

Le substrat diamant 4 comprend une face supérieure comportant neuf paires de bornes métallisées 5 arrangées suivant une matrice 3x3, chaque paire de bornes métallisées 5 constituant les deux bornes 5 d'un interrupteur diamant 6, ces dernières étant espacées d'environ 10 mm pour tenir une différence de potentiel importante entre ces deux bornes. De telles bornes métallisées 5 sont par exemple obtenues sur le substrat diamant 4 par un procédé de métallisation comportant les étapes suivantes :
- dépôt d'une résine photosensible sur la face supérieure du substrat diamant ;
- élimination de la résine en regard des surfaces à métalliser par rayonnement au travers d'un masque ;
- métallisation par vaporisation successive de Titane-Platine-Or sur la surface du substrat diamant recouverte partiellement de résine ;
- élimination de la résine restante en plongeant le substrat diamant dans l'acétone.

Conformément aux figures 1 et 2, des sources optiques ultraviolet 7 sont disposées en regard de chaque intervalle séparant les deux bornes 5 d'un interrupteur diamant 6, ces sources optiques 7 présentant un faisceau, représenté en pointillé sur les figures, permettant d'irradier sur commande la surface de diamant 4 séparant les deux bornes 5 d'un interrupteur diamant 6 afin de provoquer une conduction électrique entre ces deux bornes 5. Les sources optiques 7 sont avantageusement supportées par une plaque, non représentée sur ces figures, rapportée sur des pieds portés 8 par la face supérieure du socle 3, et sont commandées indépendamment les unes des autres par un circuit de commande constituant le circuit de commande du convertisseur.

Les trois connecteurs d'entrée 1 et les trois connecteurs de sortie 2 du convertisseur sont répartis respectivement en regard des trois lignes et des trois colonnes de la matrice d'interrupteurs diamant 6, l'extrémité de chacun des connecteurs 1 et 2 étant supportée par le socle 3. Chaque connecteur d'entrée 1 est connecté électriquement par des fils d'aluminium 9 à l'une des deux bornes 5 des trois interrupteurs diamant 6 disposés dans l'alignement du connecteur d'entrée 1, l'autre borne 5 de l'interrupteur diamant 6 étant connectée avec le connecteur de sortie 2 disposé en regard de la colonne sur laquelle se trouve l'interrupteur diamant 6.

Un tel convertisseur matriciel présente l'avantage de posséder des interrupteurs diamant qui peuvent supporter de grandes tensions à leurs bornes et qui assurent naturellement une bidirectionnalité du courant au travers du convertisseur. De plus, la commande d'un tel convertisseur se fait par la commande optique des interrupteurs diamant, cette dernière présentant l'avantage d'être naturellement isolée du potentiel électrique aux bornes de l'interrupteur. Enfin, de par sa topologie modulable grâce à la commande optique, un tel convertisseur matriciel permet tout type de conversion tel que de la conversion directe AC/AC monophasé ou triphasé, de la conversion AC/DC ou DC/DC lorsqu'il est connecté à une source de tension continue.

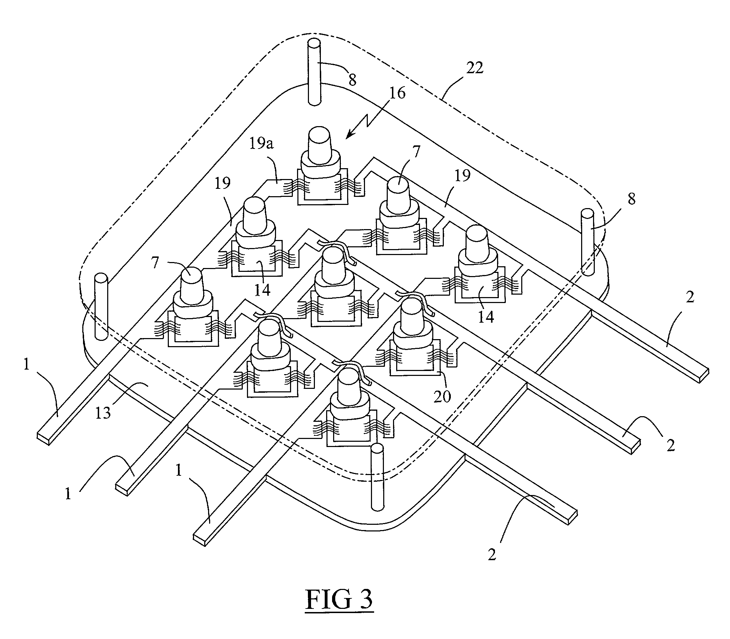

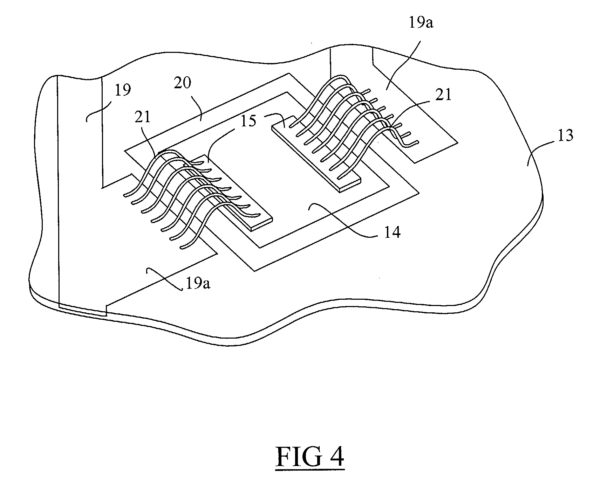

La figure 3 représente une variante de réalisation du convertisseur selon l'invention. Conformément à cette figure, le convertisseur matriciel comporte un substrat céramique 13 en nitrure d'aluminium AlN sur lequel sont rapportés trois connecteurs d'entrée 1 et trois connecteurs de sortie 2. Le substrat céramique 13 comporte neuf cavités réparties suivant une matrice 3x3, chaque cavité comprenant un substrat diamant 14 carré d'environ 10 mm de côté, entouré de verre 20 ainsi que cela est représenté plus en détail à la figure 4. La zone en verre 20, éventuellement chargé de céramique, réalise une interface entre le substrat diamant 14 et le substrat céramique 13 qui présente l'avantage de posséder un coefficient de dilatation α proche de 3,5, permettant d'atténuer les efforts provoqués par la dilatation différentielle entre le diamant (α=1) et le substrat AlN (α=4,5).

Conformément à la figure 4, chaque substrat diamant 14 comporte deux bornes métallisées 15 disposées en deux points diamétralement opposés, ces bornes 15 constituant les deux bornes d'un interrupteur diamant 16 et étant reliées par des fils d'aluminium 21 à deux plots de connexion 19a portés par le substrat en AlN 13 à la périphérie de la couche de verre 20. Les plots de connexion 19a sont reliés à des pistes conductrices 19 formées par métallisation de la surface du substrat 13 en AlN, les pistes 19 étant agencées de telle sorte qu'elles relient un connecteur d'entrée 1 avec l'une des bornes 15 des trois interrupteurs diamant 16 disposés suivant une même ligne de la matrice, les trois autres bornes 15 de ces interrupteurs diamant 16 étant connectées respectivement aux trois connecteurs de sortie 2.

Des sources optiques ultraviolet 7, représentées uniquement sur la figure 3, sont disposées en regard de chacun des substrats diamant 14, chaque source optique 7 pouvant irradier sur commande l'intervalle séparant les deux bornes 15 d'un interrupteur diamant 16 afin de provoquer une conduction électrique entre ces deux bornes 15. Ces sources optiques 7 sont avantageusement supportées par une plaque 22, représentée en trait mixte sur la figure 3, rapportée sur des pieds 8 portés par la face supérieure du substrat céramique 13, les sources optiques 7 étant commandées individuellement par un circuit de commande.

La face inférieure du substrat céramique 13 est avantageusement balayée par un fluide caloporteur canalisé par un collecteur non représenté sur les figures permettant d'évacuer la chaleur dégagée au niveau des interrupteurs diamant 16 lors du fonctionnement du convertisseur matriciel. Dans un tel cas, l'épaisseur des substrats diamant sera adaptée à la tension de fonctionnement du convertisseur et pourra par exemple varier d'une épaisseur de 50 µm, pour tenir une différence de potentiel entre les bornes de l'interrupteur diamant et fluide caloporteur de l'ordre à 5kV jusqu'à une épaisseur de 200 µm pour tenir une différence de potentiel de l'ordre de 20 kV.

Une telle variante de réalisation présente l'avantage de nécessiter une moins grande surface de substrat diamant que le mode de réalisation de la figure 1, ce qui permet de réduire le coût de fabrication d'un tel convertisseur.

Le convertisseur selon l'invention peut avantageusement être utilisé pour commander un moteur de traction d'un véhicule ferroviaire à partir d'une tension caténaire, sa topologie modulable lui permettant de s'adapter par simple modification de sa commande des interrupteurs diamant à différents types de tension caténaire.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

## Revendications

1. Convertisseur matriciel pour la transformation d'énergie électrique entre au moins une source de tension (1), notamment un réseau d'alimentation, et au moins une source de courant (2), notamment une charge, ledit convertisseur comportant une matrice d'interrupteurs (6 ; 16) reliant lesdites sources de tension (1) audites sources de courant (2), **caractérisé en ce que** lesdits interrupteurs (6 ; 16) comportent deux bornes (5 ; 15) qui sont reliés entre elles par une couche de diamant photoconductrice (4; 14), la commande de chaque interrupteur (6; 16) étant réalisée au moyen d'une source optique (7) venant irradier la couche de diamant (4 ; 14) interposée entre les deux bornes (5 ; 15) de l'interrupteur (6 ; 16).

2. Convertisseur matriciel selon la revendication 1, **caractérisé en ce que** lesdites bornes (5 ; 15) de la matrice d'interrupteurs (6 ; 16) sont disposées dans un même plan.

3. Convertisseur matriciel selon l'une quelconque des revendications 1 à 2, **caractérisé en ce que** ladite couche de diamant de l'interrupteur (6 ; 16) est constituée d'un substrat diamant (4 ; 14) obtenu par un procédé CVD de dépôt chimique en phase vapeur.

4. Convertisseur matriciel selon la revendication 3, **caractérisé en ce que** les bornes (5 ; 15) sont réalisées par métallisation du substrat diamant (4 ; 14) par vaporisation successive de Titane-Platine-Or.

5. Convertisseur matriciel selon l'une quelconque des revendications 3 à 4, **caractérisé en ce que** ladite source optique (7) est une source ultraviolette.

6. Convertisseur matriciel selon l'une quelconque des revendications 3 à 5, **caractérisé en ce qu'**un unique substrat diamant (4) supporte l'ensemble des bornes (5 ; 15) de la matrice d'interrupteurs (6).

7. Convertisseur matriciel selon l'une quelconque des revendications 1 à 5, **caractérisé en ce que** chaque interrupteur (16) du convertisseur est formé par un substrat diamant individuel (14) qui est supporté par un substrat céramique (13), ledit substrat diamant individuel (14) étant lié au substrat céramique support (13) par l'intermédiaire d'une couche de verre (20).

8. Convertisseur matriciel selon la revendication 7, **caractérisé en ce que** chaque interrupteur (16) comporte deux bornes (15) reliées respectivement à une source de tension (1) et à une source de courant (2) par des pistes conductrices (19) portées par ledit substrat céramique support (13).

9. Convertisseur matriciel selon l'une quelconque des revendications 6 à 7, **caractérisé en ce que** ledit substrat céramique (13) est en nitrure d'aluminium AlN.

10. Convertisseur matriciel selon l'une quelconque des revendications 7 à 9, **caractérisé en ce que** ledit substrat céramique (13) comporte une face opposée à la face supportant les pistes conductrices (19) qui est refroidie par l'écoulement d'un fluide caloporteur.
